(19) Europäisches Patentamt / European Patent Office / Office européen des brevets

(11) **EP 4 572 040 A1**

(12) **DEMANDE DE BREVET EUROPEEN**

(43) Date de publication:
**18.06.2025   Bulletin 2025/25**

(21) Numéro de dépôt: **24218706.0**

(22) Date de dépôt: **10.12.2024**

(51) Classification Internationale des Brevets (IPC):
*H01S 5/02* *(2006.01)*   *H01S 5/12* *(2021.01)*
*H01S 5/22* *(2006.01)*   *H01S 5/10* *(2021.01)*
*H01S 5/34* *(2006.01)*   *H01S 5/20* *(2006.01)*
*H01S 5/32* *(2006.01)*

(52) Classification Coopérative des Brevets (CPC):
**H01S 5/1237; H01S 5/021; H01S 5/1064;**
**H01S 5/2205;** H01S 5/0216; H01S 5/04253;
H01S 5/04257; H01S 5/1039; H01S 5/1231;
H01S 5/2027; H01S 5/22; H01S 5/222;
H01S 5/3214; H01S 5/3401; H01S 2301/176

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité:   **14.12.2023   FR 2314205**

(71) Demandeur: **Commissariat à l'Energie Atomique et aux Energies Alternatives**
**75015 Paris (FR)**

(72) Inventeurs:
• **BADHISE, Ben Bakir**
  **38054 GRENOBLE CEDEX 09 (FR)**
• **VOLPERT, Marion**
  **38054 GRENOBLE CEDEX 09 (FR)**
• **BRIA, Toufiq**
  **38054 GRENOBLE CEDEX 09 (FR)**

(74) Mandataire: **Cabinet Camus Lebkiri**
**25 rue de Maubeuge**
**75009 Paris (FR)**

(54) **SOURCE LUMINEUSE COMPRENANT UNE CAVITÉ RÉSONANTE À CONTRERÉACTION RÉPARTIE ET PROCÉDÉ DE FABRICATION D'UNE TELLE SOURCE LUMINEUSE**

(57)   Un aspect de l'invention concerne une source lumineuse à contreréaction répartie (101) comprenant un empilement de couches (103) s'étendant parallèlement à un substrat (102), la source (101) comprenant également une première couche métallique (111) s'étendant entre le substrat (102) et l'empilement (103).

[Fig. 1]

EP 4 572 040 A1

**Description**

**DOMAINE TECHNIQUE DE L'INVENTION**

Le domaine technique de l'invention est celui de l'intégration d'une source lumineuse, par exemple de type laser, comprenant une cavité résonante à contreréaction répartie dite « DFB » pour « Distributed feedback » en anglais.

**ARRIÈRE-PLAN TECHNOLOGIQUE DE L'INVENTION**

Les sources lumineuses intégrables sur substrats, telles que les sources à contreréaction répartie, présentent de multiples applications comme par exemple la détection photoacoustique de composés chimiques. Afin de tirer parti des avantages offerts par plusieurs technologies distinctes, il est recherché d'intégrer des sources lumineuses fabriquées au moyen d'une technologie particulière sur un substrat non issu de cette technologie. On parle alors d'intégration « hybride » ou de sources « hybrides ». Citons par exemple l'intégration de sources lumineuses réalisées à partir de matériaux dits « III-V » sur un substrat semiconducteur en silicium.

Les matériaux III-V sont des alliages semiconducteurs comprenant un matériau semiconducteur appartement au groupe III (colonne 13 du tableau périodique des éléments) et un matériau semiconducteur appartenant au groupe V (colonne 15 du tableau périodique des éléments). Les alliages III-V fréquents comprennent par exemple l'InP, l'InAs, le GaAs, le GaN, le InSb ou leurs alliages. Les sources lumineuses, dites « III-V », sont de bonnes candidates pour émettre un rayonnement dans une gamme spectrale étendue, telle que l'infrarouge moyen et lointain. Ces sources présentent en revanche des contraintes d'intégration fortes, notamment lorsqu'elles doivent être intégrées au substrat de silicium.

Une source lumineuse à contreréaction répartie, qu'elle soit de type III-V ou non, comprend une cavité formée par un empilement de couches comprenant une région dite « active » ou « amplificatrice » et deux couches semiconductrices dites « cladding » en anglais. La région active est configurée pour émettre un champ électromagnétique, par émission spontanée et/ou stimulée. Les couches de cladding sont adjacentes à la région active et disposées de part et d'autre de celle-ci pour confiner certains modes du champ électromagnétique, dit « modes guidés ». Un réseau de diffraction permet d'appliquer une contreréaction sur le champ magnétique pour établir les modes guidés. Afin de confiner efficacement le ou les modes guidés, les couches de cladding présentent des indices optiques strictement inférieurs à l'indice optique moyen de la région active. Par exemple, lorsque la région active est composée d'un multicouches de InGaAs/AlInAs ou de InAlAs/AlGaInAs, les couches de cladding sont alors réalisées en InP.

Une source lumineuse III-V, dont l'empilement de couches est directement disposé sur un substrat Si, peut subir de fortes pertes optiques, handicapantes pour son utilisation. En effet, le silicium a un indice optique supérieur à celui des matériaux III-V, tels que l'InP, et donc supérieur aux couches de cladding de l'empilement. Ainsi, sans disposition particulière et lorsque la pénétration du mode guidé dans les couches de cladding est importante (par exemple dans l'infrarouge moyen et lointain), ledit mode guidé peut se coupler au substrat Si et réduire l'efficacité du confinement offert par les couches de cladding.

Afin de remédier à ce problème, il est proposé que la couche de cladding séparant la région active du substrat Si, dite couche de cladding inférieure, soit relativement épaisse. Elle permet ainsi de compenser la profondeur de pénétration du mode guidé dans les couches de cladding et réduire le couplage du mode guidé avec le substrat Si. Pour un mode guidé présentant une longueur d'onde de 4,5 $\mu$m, l'épaisseur de la couche de cladding inférieure doit atteindre au moins 3,5 $\mu$m. Cela représente une contrainte supplémentaire à l'intégration de la source et également un coût en termes de matière brute conséquent. Pour un mode guidé présentant une longueur d'onde supérieure à 10 $\mu$m (infrarouge lointain), l'épaisseur de la couche de cladding inférieure devrait être supérieure à 8 $\mu$m ce qui complexifie davantage l'intégration des sources lumineuses III-V sur silicium.

Une solution proposée par le document [Coutard, J.G., Brun, M., Fournier, M. et al. « Volume Fabrication of Quantum Cascade Lasers on 200 mm-CMOS pilot line ». Sci Rep 10, 6185 (2020)] consiste à insérer une couche de faible indice optique entre la couche de cladding inférieure de l'empilement de couches et le substrat Si. Ladite couche de faible indice fait barrière à la propagation du mode guidé dans le substrat Si et permet de réduire l'épaisseur de la couche de cladding inférieure. Cette couche de faible indice est par exemple en oxyde ou en nitrure. Si le découplage entre la source III-V et le substrat Si est efficace pour un mode guidé présentant une longueur d'onde inférieure à 4 $\mu$m, le constat est différent lorsque le mode guidé présente une longueur d'onde supérieure. En effet, les oxydes ou les nitrures induisent de fortes pertes lorsque la longueur d'onde du mode guidé est supérieure à 4 $\mu$m, ce qui limite grandement la gamme spectrale de la source.

Il existe donc un besoin de réduire l'encombrement d'une source lumineuse à contreréaction répartie, intégrant sur un substrat présentant un fort indice optique, quel que soit la gamme spectrale considéré.

**RÉSUMÉ DE L'INVENTION**

L'invention permet de résoudre, au moins en partie, les problèmes précités.

Plus particulièrement, l'invention concerne une source lumineuse comprenant :

- un substrat s'étendant parallèlement à un plan ;

- une cavité résonante à contreréaction répartie (également appelée « cavité résonante à contreréaction distribuée » ou « DFB » pour « Distributed Feedback » en anglais), configurée pour qu'au moins un mode stationnaire d'un champ électromagnétique, dit « mode guidé résonant », s'établisse parallèlement au substrat, ladite cavité résonante comprenant un empilement de :

  - une première couche de confinement, dite « couche de confinement inférieure », s'étendant parallèlement au substrat ;

  - une couche active, configurée pour générer ledit champ électromagnétique, ladite couche active, s'étendant sur la couche de confinement inférieure ;

  - une deuxième couche de confinement, dite « couche de confinement supérieure », s'étendant sur la couche active.

La source lumineuse est remarquable en ce que la cavité résonante comprend une couche métallique, dite « couche métallique inférieure », s'étendant parallèlement au substrat, entre le substrat et l'empilement de couches et en ce que la couche de confinement inférieure s'étend contre la couche métallique inférieure.

Par « parallèle » ou « parallèlement » à un plan ou une direction et respectivement « perpendiculaire » ou « perpendiculairement » à un plan ou une direction, on entend parallèle au plan ou à la direction à 20° près (c'est-à-dire avec un angle par rapport à ce plan ou cette direction compris dans [-20° ; +20°]), voire 10° près, et respectivement perpendiculaire au plan ou à la direction à 20° près (c'est-à-dire avec un angle par rapport à ce plan ou cette direction compris dans [70° ; 110°]), voire 10° près.

La couche métallique inférieure remplace la couche d'oxyde ou de nitrure décrite par le document [Coutard, J.G., Brun, M., Fournier, M. et al. « Volume Fabrication of Quantum Cascade Lasers on 200 mm-CMOS pilot line ». Sci Rep 10, 6185 (2020)] et discuté plus haut. La couche métallique inférieure ne présente pas les problèmes d'absorption des couches d'oxyde ou de nitrure.

La présence de la couche métallique inférieure interdit la transmission des modes guidés résonants vers le substrat. Elle améliore ainsi le confinement des modes guidés résonants dans l'empilement. Ainsi, quand bien même le substrat présenterait un indice optique plus élevé que l'indice effectif vu par les modes guidés résonants dans la cavité, la couche métallique inférieure interdit la transmission des modes vers le substrat. La couche métallique inférieure permet donc d'intégrer la source sur un substrat à fort indice optique, par exemple en silicium.

La propagation du mode guidé résonant dans le substrat, c'est-à-dire hors de la cavité, induit des pertes optiques élevées. La couche métallique inférieure, par sa nature métallique, peut également induire des pertes optiques, notamment par l'absorption d'une partie du rayonnement. Toutefois les pertes optiques dues à la couche métallique inférieure sont plus faibles que les pertes optiques dans le substrat. La couche de confinement inférieure peut donc être amincie par rapport à une source de l'art antérieur présentant une couche de confinement relativement épaisse. La source selon l'invention peut donc être intégrée sur un substrat présentant un fort indice tout en présentant un encombrement réduit.

L'interaction du mode guidé résonant avec la couche métallique inférieure a lieu sur une large gamme spectrale. Plus précisément, les indices de réfractions des métaux, tels que celui de l'or, exhibent une partie imaginaire très élevée (par exemple supérieure à 10 pour l'or), augmentant sensiblement avec la longueur d'onde. Ceci a pour effet de limiter très drastiquement la pénétration du mode optique dans la couche métallique. La longueur de pénétration d'un mode infrarouge dans l'or est par exemple inférieure 100 nm. Par conséquent toute propagation dans le substrat est interdite. Ainsi, l'épaisseur de la couche métallique inférieure ne varie que peu, voire pas du tout, sur une large gamme spectrale de modes guidés résonants. L'épaisseur de la couche métallique inférieure peut donc être constante pour une large gamme spectrale. L'encombrement vertical de la source (c'est-à-dire mesuré perpendiculairement au substrat) ne varie que peu, voire pas, pour une large spectrale.

Il n'était pas évident pour la personne du métier de remplacer la couche d'oxyde décrite par le document [Coutard, J.G., Brun, M., Fournier, M. et al. « Volume Fabrication of Quantum Cascade Lasers on 200 mm-CMOS pilot line ». Sci Rep 10, 6185 (2020)] par la couche métallique inférieure et déposer première couche de confinement inférieure contre cette couche métallique inférieure. En effet, de par la nature ondulatoire des modes guidés résonants dans une cavité à DFB, tous les éléments constitutifs de la source sont intriqués. Le confinement résulte donc de multiples corrélations entre les éléments constitutifs de la source. Pour preuve, le dimensionnement de source optique infrarouge fait généralement intervenir une étape de calcul numérique, seule capable de déterminer l'effet d'une modification d'un des éléments constitutifs de la source. Un raisonnement perturbatif (c'est-à-dire considérant les éléments constitutifs de la source comme décorrélés les uns des autres) ne permet pas de déterminer l'effet d'une modification d'un des éléments sur les modes guidés résonants. Dès lors, la seule mobilisation des connaissances générales de la personne du métier n'aurait pas pu lui permettre d'anticiper l'effet de la permutation de la couche d'oxyde du document précité par une couche métallique. Elle ne se serait par exemple pas attendue à ce que la couche métallique inférieure permette d'améliorer l'encombrement de la source tout en réduisant les pertes optiques des modes guidés résonants.

La couche métallique inférieure peut également être utilisée comme contact électrique (autrement dit comme électrode) pour réaliser l'injection des porteurs de charges dans l'empilement afin de stimuler la génération des modes guidés résonants.

La couche métallique inférieure permet également de dissiper plus efficacement la chaleur dégagée par l'empilement vers l'extérieur. En effet, les métaux sont de bons conducteurs thermiques. La couche métallique inférieure au contact de l'empilement permet de réaliser un transfert thermique par conduction depuis l'empilement vers un point froid (tel que le substrat ou un dissipateur thermique). L'efficacité d'une source lumineuse dépend fortement de la température de cette dernière. La couche métallique inférieure permet donc d'améliorer l'efficacité de la source.

Par indice optique, on entend également indice de réfraction. Par indice optique effectif, on entend l'indice optique vu par le mode guidé résonant dans l'empilement.

Avantageusement, l'empilement de couches présente une hauteur, mesurée perpendiculairement au substrat, l'empilement de couches comprenant en outre un premier côté, s'étendant perpendiculairement au substrat sur au moins une partie de la hauteur de l'empilement de couches et s'étendant parallèlement à une première direction parallèle au substrat dite « direction de propagation », l'empilement de couches présentant, sur son premier côté, un premier réseau de diffraction configuré pour appliquer une contreréaction répartie sur ledit au moins un mode guidé résonant.

Le premier réseau de diffraction permet de réaliser la contreréaction répartie sur les modes guidés résonants et ainsi sélectionner au moins un mode guidé résonant dans la cavité résonante.

La formation du réseau de diffraction sur un côté de l'empilement au lieu de le réaliser sur l'empilement permet de réduire davantage l'épaisseur totale de la source. En effet, positionner un réseau de diffraction sur ou sous l'empilement de couches oblige à déposer une épaisseur de matière suffisante pour graver le réseau de diffraction. Selon la profondeur de gravure du réseau ou des indices optiques des matériaux composant le réseau, cette épaisseur pouvait s'avérer importante.

Avantageusement, le premier côté s'étend sur une hauteur de la couche de confinement supérieure, sur une hauteur de la couche active et au moins sur une partie d'une hauteur de la couche de confinement inférieure. Le premier côté peut également s'étendre sur toute la hauteur de la couche de confinement inférieure.

Avantageusement, l'empilement de couches présente une largeur, mesurée perpendiculairement à la direction de propagation, le premier réseau de diffraction étant formé de sorte que la largeur de l'empilement de couches varie périodiquement en fonction d'une position le long de la direction de propagation.

Le réseau de diffraction présente donc une série de fentes ou tranchées s'étendant perpendiculairement au substrat et formant, suivant la direction de propagation, un réseau de diffraction. Lorsque le réseau de diffraction est positionné sur un côté, chaque fente ou tranchée peut être creusée (en direction du centre de l'empilement) aussi profondément que souhaité. Il est donc possible d'ajuster le couplage du réseau de diffraction avec les modes guidés résonants sans pour autant augmenter la hauteur de la source. Des fentes s'étendant perpendiculairement au substrat sont également plus simples à graver.

La formation de réseaux de diffraction latéraux permet également de fabriquer plusieurs sources différentes sur un même substrat et/ou lors d'une même étape de fabrication. Les sources peuvent notamment présenter des réseaux présentant des forces de couplage différentes. La formation de réseaux de diffractions latéraux permet de graver, dans une même étape, des corrugations (ou structurations) de profondeurs différentes (la profondeur d'une corrugation pour un réseau latéral se mesurant parallèlement au substrat). À contrario, la formation d'un réseau sur ou sous l'empilement (par exemple tel que réalisé dans le document précité [Coutard 2020]) oblige à former des réseaux présentant les mêmes profondeurs de corrugations (la profondeur étant mesurée perpendiculairement au substrat) et donc les mêmes forces de couplage pour toutes les sources.

Avantageusement, le premier réseau de diffraction présente une première longueur, mesurée selon la direction de propagation, et, pour au moins un mode guidé résonant de la cavité résonante, une première force de couplage avec ledit mode guidé résonant, le produit de la première force de couplage pour ledit au moins un mode guidé résonant avec la première longueur du réseau de diffraction étant compris entre 1 et 2,5.

La force de couplage peut être vue comme une constante proportionnelle à un contraste des indices effectifs vu par les modes guidés résonants en interaction avec le réseau de diffraction. Le contraste est usuellement défini comme une différence d'indices effectifs $\Delta n$ dudit mode guidé résonant dans des zones gravées du réseau et non gravées du réseau. La force de couplage $\kappa$ est par exemple calculée par

$$\kappa = \frac{2\,\Delta n}{\lambda}$$

où $\lambda$ est la longueur d'onde du mode guidé résonant considéré. Les différents indices effectifs vus par les modes guidés résonants dépendent de la forme des zones gravées et non gravées, de la profondeur des zones gravées par rapport aux zones non gravées, ainsi que leur rapport cyclique.

Conserver un produit de la longueur avec la force de couplage compris entre 1 et 2,5 permet d'obtenir une cavité résonante efficace. Le premier réseau présente ainsi une force suffisante pour appliquer une contreréaction répartie sur les champs électromagnétiques dans l'empilement.

Avantageusement, l'empilement de couches comprend un deuxième côté, opposé au premier côté, et s'étendant sur au moins une partie de la hauteur de l'empilement de couches, l'empilement de couches présentant, sur son deuxième côté, un deuxième réseau de diffraction configuré pour appliquer une contreréaction répartie sur ledit au moins un mode guidé résonant, le premier réseau de diffraction présentant un premier pas et le deuxième réseau de diffraction présentant un deuxième pas égal au premier pas.

Par « le deuxième pas égal au premier pas », on entend que le deuxième est égal au premier pas à 20% près, voire à 10% près.

Le deuxième réseau permet ainsi de renforcer la contreréaction répartie dans la cavité résonante. Il offre également les mêmes avantages d'encombrement et de facilité de fabrication que le premier réseau de diffraction.

Préférentiellement, le deuxième côté s'étend sur la hauteur de la couche de confinement supérieure, sur la hauteur de la couche active et au moins sur une partie de la hauteur de la couche de confinement inférieure. Le deuxième côté peut également s'étendre sur toute la hauteur de la couche de confinement inférieure.

Avantageusement, le deuxième réseau de diffraction présente une deuxième longueur et une deuxième force de couplage avec ledit au moins un mode guidé résonant, le produit de la deuxième force de couplage avec la deuxième longueur étant également compris entre 1 et 2,5.

Avantageusement, l'empilement de couches présente une première face, dite « face inférieure » et une deuxième face, dite « face supérieure », opposée à la face inférieure, la couche métallique inférieure s'étendant contre la face inférieure de l'empilement de couches.

Avantageusement, l'empilement de couches présentant, sur sa face supérieure, un troisième réseau de diffraction configuré pour appliquer une contreréaction répartie sur ledit au moins un mode guidé résonant. Le troisième réseau de diffraction permet de renforcer davantage la contreréaction répartie

Avantageusement, le troisième réseau de diffraction présente un troisième pas égal au premier pas. Ainsi, la contreréaction est renforcée.

Avantageusement, la couche de confinement inférieure présente une première épaisseur, mesurée perpendiculairement au substrat, pour laquelle les pertes optiques d'au moins un mode guidé résonant de l'empilement sont fonction de la première épaisseur selon un régime asymptotique.

Une partie du mode guidé résonant dans la cavité peut être absorbé par la couche métallique inférieure de par le caractère métallique de cette dernière. Augmenter la première épaisseur de la couche de confinement inférieure permet de réduire le niveau d'absorption dans la couche métallique. La tendance d'évolution des pertes optiques en fonction de la première épaisseur permet de déterminer une épaisseur correspondant à des pertes optiques acceptables. Un critère de sélection de la première épaisseur est par exemple le régime asymptotique des pertes optiques. Dans le régime asymptotique, la première épaisseur augmente plus rapidement que les pertes sont réduites. La première est donc, dans ce régime, suffisamment épaisse.

Avantageusement, la cavité résonante comprend également une couche métallique additionnelle, dite « couche métallique supérieure », s'étendant contre la face supérieure de l'empilement, la deuxième couche de confinement supérieure présente présentant une deuxième épaisseur, mesurée perpendiculairement au substrat, pour laquelle les pertes optiques d'au moins un mode guidé résonant de l'empilement sont fonction de la deuxième épaisseur selon un régime asymptotique.

La couche métallique supérieure offre plusieurs avantages. Elle permet par exemple de réaliser, avec la couche métallique inférieure, l'injection des porteurs de charge pour stimuler l'émission de photons par l'empilement (et en l'occurrence par une couche active). Ainsi, il n'est pas nécessaire de recourir à des couches interstitielles, conductrices et transparentes (aux modes guidés sélectionnés), insérées dans l'empilement pour réaliser un report des contacts électriques. La fabrication de l'empilement est facilitée et l'injection des porteurs est uniformisée.

La présence de la couche métallique supérieure peut également bloquer la transmission des modes guidés hors de la cavité, de la même manière que la couche métallique inférieure (et en la présence d'un milieu à fort indice optique). Elle présente toutefois le désavantage d'induire des pertes dues à sa nature métallique. Toutefois, la sélection d'une deuxième épaisseur de la couche de confinement supérieure en fonction du régime d'évolution des pertes en fonction de la deuxième épaisseur permet d'obtenir une source avec des pertes acceptables et une épaisseur raisonnable.

Avantageusement, la couche métallique inférieure est réalisée à partir de Au, Ag ou Ti.

L'invention concerne également un procédé de fabrication d'une source lumineuse comprenant les étapes de :

- fournir un premier substrat présentant une première face ;

- fournir un deuxième substrat présentant une deuxième face ;

- métalliser la première face du premier substrat de manière à former une première sous-couche métallique s'étendant sur la première face du premier substrat ;

- métalliser la deuxième face du deuxième substrat de manière à former une deuxième sous-couche métallique s'étendant sur la deuxième face du deuxième substrat ;

- reporter la deuxième sous-couche métallique du deuxième substrat sur la première sous-couche métallique du premier substrat de sorte que les première et deuxième sous-couches métalliques forment une couche métallique, dite « couche métallique inférieure », s'étendant parallèlement au premier substrat ;

- former une cavité résonante à contreréaction répartie configurée pour qu'au moins un mode stationnaire d'un champ électromagnétique, dit « mode guidé résonant », s'établisse parallèlement au premier substrat, la formation de la cavité résonante comprenant les étapes de :

    - graver le deuxième substrat de manière à former une première couche de confinement, dite « couche de confinement inférieure », s'étendant parallèlement au premier substrat et contre la couche métallique inférieure ;

    - former une couche active, configurée pour générer ledit champ électromagnétique, ladite couche active s'étendant sur la couche de confinement inférieure ; et

    - former une deuxième couche de confinement, dite « couche de confinement supérieure », s'étendant sur la couche active.

Ce procédé permet de fabriquer une source lumineuse selon l'invention qui peut tirer parti d'un report métal/métal de deux substrats réalisés dans des matériaux différents, par exemple en Si et en matériau III-V.

Avantageusement, le procédé comprend une étape de détermination d'une première épaisseur pour la couche de confinement inférieure, pour laquelle les pertes optiques d'au moins un mode guidé résonant de la cavité résonante sont fonction de cette première épaisseur selon un régime asymptotique, l'étape de gravure du deuxième substrat étant réalisée de sorte que la couche de confinement inférieure résultante présente la première épaisseur déterminée.

Avantageusement, le procédé comprend une étape de détermination d'une deuxième épaisseur pour la couche de confinement supérieure, pour laquelle les pertes optiques d'au moins un mode guidé résonant de la cavité résonante sont fonction de cette deuxième épaisseur selon un régime asymptotique, l'étape de formation de la couche de confinement supérieure étant réalisée de sorte que la couche de confinement supérieure résultante présente la deuxième épaisseur déterminée.

Avantageusement, l'étape de détermination de la deuxième épaisseur est réalisée avant l'étape de détermination de la première épaisseur. Ceci permet de réaliser une optimisation de la première épaisseur en considérant une deuxième épaisseur déjà optimale. Dès la détermination de la première épaisseur n'est pas perturbée par une deuxième épaisseur non optimisée.

Avantageusement, le procédé comprend une gravure de l'empilement de couches de sorte que ledit empilement de couches, présentant une hauteur mesurée perpendiculairement au premier substrat, comprenne un premier côté, s'étendant perpendiculairement au premier substrat sur au moins une partie de la hauteur de l'empilement de couches et s'étendant parallèlement à une première direction parallèle au premier substrat dite « direction de propagation », la gravure de l'empilement de couches étant réalisée de sorte que l'empilement de couches présente, sur son premier côté, un premier réseau de diffraction configuré pour appliquer une contreréaction répartie sur ledit au moins un mode guidé résonant.

Avantageusement, le procédé comprend une étape de dépôt conforme d'une première couche isolante contre le premier côté de l'empilement de couches et une étape de dépôt conforme d'une couche métallique supplémentaire sur la première couche isolante.

## BRÈVE DESCRIPTION DES FIGURES

L'invention et ses différentes applications seront mieux comprises à la lecture de la description qui suit et à l'examen des figures qui l'accompagnent. Les figures sont présentées à titre indicatif et nullement limitatif de l'invention. Sauf précision contraire, un même élément apparaissant sur des figures différentes présente une référence unique.

Les [Fig. 1] et [Fig. 2] présentent un premier mode de réalisation d'une source lumineuse selon l'invention.

La [Fig. 3] présente un premier résultat d'une analyse modal réalisée à partir d'une source lumineuse selon l'invention.

Les [Fig. 4] et [Fig. 5] présentent des deuxième et troisième résultats d'une analyse modal réalisée à partir d'une source lumineuse selon l'invention.

La [Fig. 6] présente une étape d'un procédé de fabrication selon l'invention permettant de fabriquer la source lumineuse des figures 1 et 2.

## DESCRIPTION DÉTAILLÉE

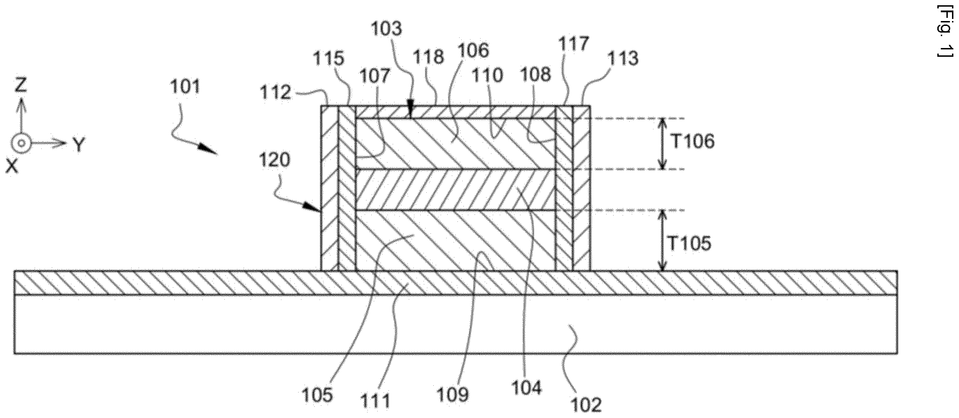

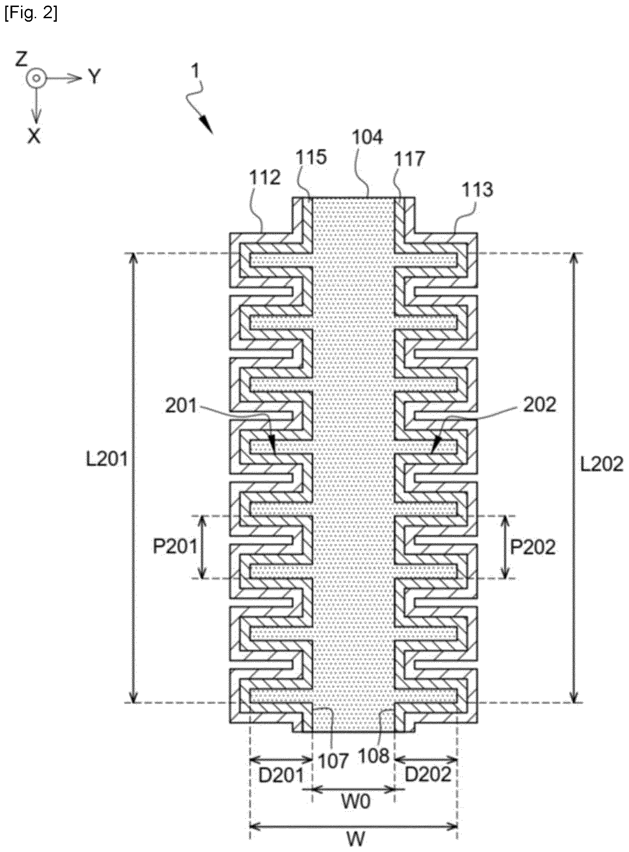

Les figures 1 et 2 représentent schématiquement un premier mode de réalisation d'une source lumineuse 101 selon l'invention. Elles montrent en outre un repère orthonormé {X ; Y ; Z}. La figure 1 représente une vue en coupe dans un plan {Y ; Z} tandis que la figure 2 représente une vue en coupe dans un plan {X ; Y}.

La source lumineuse 101 comprend un substrat 102, une cavité résonante 120.

Le substrat 102 s'étendant parallèlement à un plan {X ; Y}. La figure 1 ne représente qu'une portion du substrat 102. Ce dernier pouvant être massif, il peut présenter des dimensions très grandes par rapport aux autres éléments de la source 101. Le substrat 102 est par exemple en silicium.

La cavité résonante 120, est par exemple une cavité de source laser ou une cavité de source électroluminescente. La cavité 120 est avantageusement configurée pour réaliser une émission d'un faisceau lumineux dans une gamme de longueurs d'ondes comprise entre 0,8 μm et 20 μm, comprenant l'infrarouge proche et une partie de l'infrarouge moyen. La cavité 120 est dite à « émission frontale ». C'est-à-dire que l'émission est réalisée par une surface latérale de la cavité 120, orientée dans le cas présent selon une première direction X aussi appelée « direction de propagation ».

Dans le mode de réalisation de la figure 1, la cavité 120 présente une forme de crête, dite « ridge » en anglais, s'étirant selon la direction de propagation X. Autrement dit, elle présente un rapport d'aspect important avec une longueur, mesurée selon X, comprise entre 20 μm et 1000 μm, voire entre 100 μm et 5000 μm, et une largeur, mesurée selon une deuxième direction Y, parallèle à la direction de propagation X, comprise entre 5 μm et 100 μm, et préférentiellement entre 5 μm et 20 μm. La cavité 120 peut présenter une hauteur, mesurée selon une troisième direction Z, comprise entre 2 μm et 20 μm, et préférentiellement entre 2 μm et 10 μm.

La cavité 120 est configurée pour émettre un champ électromagnétique et confiner ce champ électromagnétique dans un ou plusieurs modes stationnaires également appelé « modes guidés résonants » (que l'on nommera indifféremment « modes guidés » ou « modes résonants »). Il peut s'agir de modes guidés, tels que ceux observables dans une source laser. La cavité est particulière en ce que chaque mode guidé est parallèle au plan {X ; Y} (c'est-à-dire parallèle au substrat 102). Par mode parallèle au plan, on entend que le champ présente, de manière exclusive :

- une polarisation du champ électrique perpendiculaire au plan {X ; Y} ; ou

- une polarisation du champ magnétique perpendiculaire au plan {X ; Y}.

Autrement dit, le champ électromagnétique comprend par exemple :

- une polarisation du champ électrique normale au substrat 102 (c'est à dire parallèle à la direction Z) et une polarisation du champ magnétique parallèle au substrat 102 ; ou

- une polarisation du champ électrique parallèle au substrat 102 et une polarisation du champ magnétique normale au substrat 102.

La cavité 120 met en oeuvre une contreréaction répartie pour permettre l'établissement de modes résonants. En l'occurrence elle comprend deux réseaux de diffractions latéraux 201, 202 (discutés plus bas) pour réaliser la contreréaction répartie sur le champ électromagnétique.

Sauf mention contraire, un seul mode guidé du champ dans la cavité 120 sera considéré, afin de simplifier la description de l'invention. Les enseignements s'appliquent toutefois à chaque mode guidé lorsque la cavité 120 est configurée pour présenter une pluralité de modes.

Dans le mode de réalisation de la figure 1, la cavité 120 comprend un empilement 103 de couches, chaque couche s'étendant parallèlement au substrat 102. L'empilement 103 comprend par exemple une couche active 104, que l'on nomme également « région active » ou « région amplificatrice ». La couche active 104 est configurée pour émettre le champ électromagnétique. L'empilement 103 comprend également une première couche de confinement 105, dite « couche de confinement inférieure » ou « couche de cladding inférieure », s'étendant entre la région active 104 et le substrat 102. La couche active 104 repose sur la couche de confinement intérieure 105. L'empilement 103 comprend également une deuxième couche de confinement 106, dite « couche de confinement supérieure » ou « couches de cladding supérieure », reposant sur la région active 104. Les termes « inférieure » et « supérieure » sont considérés relativement à l'orientation de la figure 1. La couche active 110 sépare les deux couches de confinement 105, 106. Les trois couches 104, 105, 106 forment ainsi un empilement de couches vertical, chaque couche 104, 105, 106 s'étendant parallèlement au substrat 102. Ledit empilement 103 est délimité par un flanc s'étendant perpendiculairement au substrat 102. Ledit flanc comprend notamment deux surfaces 107, 108 formant un premier côté 107 et un deuxième côté 108. Les deux côtés 107, 108 sont opposés l'un à l'autre. Le premier côté 107 est en l'occurrence orienté selon -Y et le deuxième côté 108 est orienté selon +Y.

Les couches de confinement 105, 106 permettent de contribuer au confinement du champ électromagnétique dans la cavité 120, notamment selon la direction Z, normale au substrat 102. De la sorte, le champ électromagnétique reste majoritairement localisé au niveau de la couche active 104 et permet par exemple de favoriser l'émission stimulée de la couche active 104. Pour cela, les couches de confinement 105, 106 sont par exemple configurées pour présenter des indices optiques $n_{105}$, $n_{106}$ strictement inférieurs à un indice optique

moyen $n_{104}$ de la couche active 104. Par indice optique moyen $n_{104}$ de la couche active 104, on entend un indice optique prenant en compte les indices des couches ou sous-couches composant la couche active 104.

Les couches de confinement 105, 106 sont par exemple en alliage III-V tel que l'InP.

La couche active 104 peut être configurée pour que l'émission du champ électromagnétique soit au moins spontanée et préférentiellement spontanée et stimulée. Ce dernier cas permet un fonctionnement en mode laser de la source 101. L'émission peut être basée sur l'émission inter-bandes également appelée « interband cascade émission » en anglais. Elle peut être préférentiellement basée sur l'émission inter-sous bandes également appelée « émission à cascade quantique » ou « quantum cascade émission » en anglais. Pour permettre une émission à cascade quantique, la couche active 104 comprend par exemple un empilement de sous-couches en matériau III-V, formant une succession de puits quantiques et de barrières de potentiel. L'empilement de sous-couches s'étend par exemple parallèlement au substrat. La couche active 104 comprend par exemple une multicouche de InGaAs / AlInAs ou de InAlAs / AlGaInAs.

Les différentes couches 104, 105, 106 de la cavité 120 présentent des indices optiques différents. Toutefois, chaque mode guidé dans la cavité 120 peut voir un indice optique effectif $n_{\text{eff}}$ qui peut présenter une valeur différente des indices optiques des couches de l'empilement 103 considérées indépendamment les unes des autres. Cette différence est notamment due à la géométrie des différentes couches. C'est la raison pour laquelle l'indice optique effectif $n_{\text{eff}}$ du mode guidé est considéré. L'indice optique effectif $n_{\text{eff}}$ peut être déterminé numériquement. Une estimation de l'indice optique effectif $n_{\text{eff}}$ peut être déterminée à partir de l'indice optique moyen dans l'empilement 103. Il est toutefois préférable de prendre en compte tous les éléments permettant de réaliser le confinement du champ électrique dans la cavité 120, tels que la géométrie (épaisseur et/ou largeur) de l'empilement 103 et/ou la présence de couches réflectrices.

Le substrat 102 présente un indice optique $n_{102}$. Lorsque $n_{\text{eff}} > n_{102}$, le mode guidé de la cavité 120 n'est pas susceptible de se coupler avec le substrat 102. Le substrat 102 participe au confinement des modes guidés dans la cavité 120. En revanche, lorsque $n_{\text{eff}} < n_{102}$, le mode guidé dans la cavité 120 est susceptible de se coupler avec le substrat 102, induisant des pertes optiques et réduisant l'efficacité du la source 101.

La source 101 comprend l'insertion d'une première couche métallique 111, dite « couche métallique inférieure », entre le substrat 102 et l'empilement de couches 103. La couche métallique inférieure 111 s'étend parallèlement au substrat 102 et la première couche de confinement 105 s'étend contre cette couche métallique inférieure 111. La couche métallique inférieure 111 peut s'étendre à distance du substrat 102 ou s'étendre contre ce dernier. L'interaction des modes guidés dans la cavité 120 avec la surface de la couche métallique inférieure 111 maintient les modes guidés dans la cavité 120. De cette manière, la transmission des modes guidés vers le substrat 102 est inhibée et l'efficacité de la source 1 est conservée, quand bien même le substrat 102 montrerait un indice optique fort lui permettant de se coupler avec les modes guidés dans la cavité 120.

Dans le mode de réalisation de la figure 1, la couche métallique inférieure 111 s'étend contre le substrat 102. L'empilement 103 repose, par sa première couche de confinement 105, contre la couche métallique inférieure 111. La couche métallique inférieure 111 s'étend sur le substrat 102, sous l'empilement 103 et au-delà de l'empilement 103. La couche métallique inférieure peut être en or, argent ou titane. Elle présente une épaisseur, mesurée perpendiculairement au substrat 102 comprise entre supérieure ou égale à $\lambda/10$ où $\lambda$ est la longueur d'onde du monde guidé considéré. En considérant une gamme de longueur d'onde $\lambda$ comprise entre 0,8 $\mu$m et 20 $\mu$m, l'épaisseur de la couche métallique inférieure 111 est par exemple comprise entre 80 nm et 2 $\mu$m.

La cavité 120 comprend également une première couche isolante 115 et une deuxième couche isolante 117 s'étendant contre, respectivement, les premier et deuxièmes côtés 107, 108 de l'empilement 103. Les couches isolantes présentes préférentiellement des indices optiques inférieurs à l'indice optique effectif dans la cavité. Ainsi ces couches réalisent un confinement par contraste d'indice. Ces couches isolantes 115, 117 sont par exemple en nitrure de silicium SiN.

La cavité 120 comprend également une deuxième couche métallique 112 et une troisième couche métallique 113. Dans le mode de réalisation de la figure 1, les deuxième et troisième couches métalliques 112, 113 s'étendent perpendiculairement au substrat 102 et parallèlement aux, respectivement, premier et deuxième côtés 107, 108 de l'empilement 103. La deuxième couche métallique 112 s'étend contre la première couche isolante 115, recouvrant le premier côté 107. La troisième couche métallique 113 s'étend contre la deuxième couche isolante 117, recouvrant le deuxième côté 108.

Les deuxième et troisième couches 112, 113 permettent de confiner latéralement les modes guidés ou améliorer le confinement latéral offert par le contraste d'indices des couches isolantes 145, 117.

Les première et deuxième couches isolantes 115, 117 permettent d'isoler électriquement l'empilement 103 des deuxième et troisième couches métalliques 112, 113. En effet, l'injection de porteurs de charges, permettant de stimuler l'émission d'un champ électromagnétique est préférentiellement réalisée selon une direction perpendiculaire au substrat. Ainsi, les couches isolantes 115, 117 permettent d'éviter un court-circuit de la couche active 104 et en particulier des différentes sous-couches qui peuvent composer cette couche active 104.

Dans le mode de réalisation, les deuxième et troisième couches métalliques 112, 113 sont électriquement connectées à la couche métallique inférieure 111 dont elles sont en contact direct. Cette connexion permet de fixer le potentiel électrique des deuxième et troisième couches métalliques 112, 113.

L'empilement 103 comprend deux faces 109, 110, opposées l'une à l'autre : une première face 109, dite « face inférieure » ; et une deuxième face 110, dite « face supérieure ». La face inférieure 109 de l'empilement correspond à la face de la première couche de confinement 105 en contact avec la couche métallique inférieure 111.

La cavité 120 comprend une quatrième couche métallique 118 aussi appelée « couche métallique additionnelle » ou « couche métallique supérieure » s'étendant contre la face supérieure 110 de l'empilement 103. Ainsi, l'empilement 103 est pris en sandwich entre deux couches métalliques 111, 118 pouvant faire office d'électrodes. Ces électrodes permettent d'appliquer un champ électrique sur l'empilement 103 permettant d'assister la génération de photons dans la cavité 120 et plus spécifiquement pas la région active 104.

Afin de pouvoir appliquer un champ entre les couches métalliques inférieures et supérieures 111, 118, lesdites couches métalliques 111, 118 sont isolées électriquement l'une de l'autre. Dans le mode de réalisation de la figure 1, les couches métalliques latérales 112, 113 sont électriquement connectées à la couche métallique inférieure 111. La couche métallique supérieure 118 est donc isolées des couches métalliques latérales 112, 113. En particulier, dans le mode de réalisation de la figure 1, les première et deuxième couches isolantes 115, 117 s'étendent verticalement, au-delà de l'empilement 103 pour recouvrir des bords de la quatrième couche métallique 118.

Alternativement, les couches métalliques latérales 112, 113 pourraient être électriquement connectées à la couche métallique supérieure 118 et isolées de la couche métallique inférieure 111. Encore alternativement les couches métalliques latérales 112, 113 pourraient être connectées à une couche métallique 111, 118 différentes. Encore alternativement les couches métalliques latérales 112, 113 pourraient être isolées des couches métalliques supérieure et inférieures 111, 118.

Les deuxième, troisième et quatrième couches métalliques 112, 113, 118 peuvent être réalisées à partir d'or, d'argent ou de titane ou dans des matériaux métalliques différents.

Afin d'activer l'émission spontanée de la couche active 104, les couches de confinement 105, 106 peuvent être dopées, favorisant la conduction du courant électrique à travers la couche active 104.

La cavité 120 des figures 1 et 2 met en oeuvre une contreréaction répartie des modes résonnants, appelée « DFB » pour « distributed feedback » en anglais. Dans une cavité DFB, les modes guidés résonants s'établissent en réponse à l'action d'un réseau de diffraction s'étendant sur une face de ladite cavité. Dans le cas de la cavité 120 des figures 1 et 2, l'empilement 103 présente des corrugations latérales au niveau de ses premier et deuxième côtés 107, 108. La forme et la période de ces corrugations ainsi que le contraste d'indice (entre l'empilement et les couches isolantes 115, 117 en l'occurrence) forment des premier et deuxième réseau de diffraction 201, 202, dits « réseaux de diffraction latéraux ». De la sorte, les modes guidés dans la cavité 120 peuvent interagir avec ces réseaux de diffraction latéraux.

Dans l'exemple de la figure 2, les réseaux de diffraction latéraux 201, 202 sont formés par des tranchées périodiques, s'étendant perpendiculairement au substrat 102 (donc selon la direction Z), creusées dans l'empilement 103 selon la direction Y. Ces tranchées forment une corrugation périodique au niveau des côtés de l'empilement 103. Les tranchées sont réparties selon la direction de propagation X. Elles sont agencées, pour les premier et deuxième réseaux latéraux 201, 202, selon, respectivement, des premier et deuxième pas constants P201, P202, mesurés selon la direction de propagation X. De la sorte, chaque mode guidé s'établit parallèlement au substrat 102 et principalement dans la longueur de la cavité 120, autrement dit selon la direction de propagation X dans les figures 1 et 2.

Les corrugations latérales de la figure 2 présentent, en vue de dessus, des formes droites, similaires à des dents creusées dans l'empilement 103. La forme des corrugations peut être différente pour peu qu'elle présente des motifs périodiques. Il peut s'agit d'ondulation ou de triangles. Toutefois, d'un point de vue de la fabrication de ces corrugations, il peut être plus facile de graver des dentes droites dans les flancs de l'empilement 103.

Dans l'exemple de la figure 2, les couches isolantes 115, 117 s'étendent contre les côtés 107, 108 de l'empilement 103 et notamment de manière conforme contre les corrugations latérales. De manière similaire, les couches métalliques latérales 112, 113 s'étendent de manière conforme contre les couches isolantes 115, 117. Puisque les réseaux de diffraction 201, 202 sont en partie formé grâce au contraste d'indices avec l'empilement 103, les couches isolantes peuvent être déposés de manière différente. Par exemple, dans une variante, les couches isolantes 115, 117 peuvent être déposées de manière non-conforme contre les corrugations latérales de manière à gommer les corrugations. Dans ce cas-là les couches métalliques 112, 113 s'étendent alors contre les couches isolantes 115, 117 de manière planaire.

Les premier et deuxième pas P201, P202 des deux réseaux latéraux 201, 202 sont préférablement égaux, par exemple à 10% près, voire 5% près. Ainsi, ils renforcent constructivement la contreréaction exercée sur les modes dans la cavité 120.

L'empilement 103 peut également comprendre un troisième réseau de diffraction sur sa face supérieure 110. Il peut présenter, de la même manière que les premier et deuxième réseaux latéraux 201, 202, une corrugation périodique formée de tranchées réparties selon la direction de propagation X, avec un troisième pas constant, préférentiellement égal aux premier pas P201 du premier réseau latéral 201. Les tranchées du troisième réseau s'étendent toutefois selon une direction différente, par exemple selon la direction Y (elles peuvent être obtenues par une gravure partielle de l'empilement 103 selon la direction -Z).

En complément l'empilement 103 peut également comprendre un réseau de diffraction supplémentaire au niveau de sa face inférieure 109, sur le même principe qu'exposé ci-dessus.

Il est toutefois avantageux que la cavité 120 ne comprenne que les réseaux de diffraction latéraux 201, 202. En effet, ces derniers permettent d'obtenir une contreréaction répartie sur les modes guidés, tout en conservant un encombrement vertical restreint. En effet, il n'est pas nécessaire de disposer d'une couche épaisse sur (ou sous) l'empilement 103 pour réaliser une gravure permettant d'obtenir un réseau de diffraction. De plus, la formation d'un réseau latéral est simple à mettre en oeuvre. Elle peut être réalisée par gravure anisotrope des côtés 107, 108 de l'empilement 103. Il est également aisé de former des réseaux latéraux présentant des pas différents (et donc des ordres différents) au sein d'un même empilement 103 ou pour différents empilements 103 d'un même ensemble d'empilements 103 (par exemple fabriqués dans une même étape).

Les réseaux latéraux 201, 202, tels qu'illustrés schématiquement sur la figure 2, présentent une longueur L201, L202, mesurée selon la direction Z, égale à 20 % à la longueur de l'empilement 103. Les réseaux 201, 202 sont réalisés par gravure de fentes dans l'empilement 103.

Dans l'exemple de la figure 2, l'empilement 103 présente une largeur W, mesurée perpendiculairement à la direction de propagation Z, variant entre deux largeurs extrêmales W0 et W1. La différence entre ces deux largeurs extrêmales correspond à la profondeur D201, D202 des corrugations (en l'occurrences des tranchées), mesurée selon la direction Y.

Une force de couplage $\kappa_{201}$, $\kappa_{202}$ peut être définie pour chaque réseau latéral 201, 202. Cette force de couplage est proportionnelle à l'interaction de chaque mode guidé dans l'empilement 103 avec les réseaux de diffractions 201, 202. Chaque mode guidé est en interaction avec une force de couplage totale $\kappa$ correspondant à la somme des forces de couplage de la cavité 120.

Les forces de couplage $\kappa_{201}$, $\kappa_{202}$ des réseaux latéraux sont proportionnelles aux contrastes $\Delta n_{201}$, $\Delta n_{202}$ des indices effectifs vu par les modes guidés pour chaque réseau latéral 201, 202. Les contrastes $\Delta n_{201}$, $\Delta n_{202}$ sont fonction de la différence d'indices effectifs vu par les modes guidés dans des zones gravées du réseau (donc par exemple les indices des couches isolantes 115, 117) et non gravées du réseau. Ils dépendent également de la profondeur D201, D202 et des rapports cycliques des tranchées formant les réseaux de diffraction 201, 202. Par exemple, jusqu'à une certaine limite, plus les fentes sont profondes et plus important sont les contrastes $\Delta n_{201}$, $\Delta n_{202}$.

Les forces de couplage $\kappa_{201}$, $\kappa_{202}$ des réseaux latéraux peuvent être calculés par

$$\kappa_{201} = \frac{2\,\Delta n_{201}}{\lambda^i} \;;\; \kappa_{202} = \frac{2\,\Delta n_{202}}{\lambda^i}$$

où $\lambda^i$ est la longueur d'onde du mode guidé $i$ considéré.

Conserver un produit de la longueur L201, L202 avec une force de couplage $\kappa_{201}$, $\kappa_{202}$ tel que

$$L201 \times \kappa_{201} \in [1\,;2,5]$$

$$L202 \times \kappa_{202} \in [1\,;2,5]$$

permet d'obtenir une source 1 efficace, avec une contreréaction totale suffisante pour l'établissement de modes guidés tout en limitant l'absorption des modes par les réseaux 201, 202.

Les réseaux latéraux 201, 202 présentent des pas P201, P202 préférentiellement égaux, afin de réaliser une contreréaction répartie sur les mêmes modes guidés. Il n'est toutefois pas obligatoire que les profondeurs D201, D202 ou les longueurs L201, L202 des réseaux 201, 202 soient égales. Les longueurs des réseaux latéraux 201, 202 sont toutefois avantageusement égales à la longueur, mesurée selon la direction de propagation X, de la cavité 120. De la sorte il n'est pas nécessaire de former des fentes profondes, limitant ainsi l'atténuation des modes par les réseaux 201, 202.

Dans une variante de réalisation, la couche de confinement inférieure 105 peut présenter une forme différente, comprenant notamment une partie, dite « piédestal », s'étendant latéralement au-delà de la région active 104. La couche de confinement inférieure 105 comprend par exemple des première et deuxième sous-couches s'étendant chacune parallèlement au substrat 102 et l'une sur l'autre. La première sous-couche est en contact avec la région active 104. Elle s'étend par exemple dans le prolongement vertical (c'est-à-dire perpendiculaire au substrat 102) de la région active 104. Elle peut être délimitée par un flanc, commun au flanc délimitant la région active 104.

La deuxième sous-couche forme le piédestal. Elle s'étend contre la couche métallique inférieure 111. La première sous-couche s'étend contre la deuxième sous-couche. La deuxième sous-couche s'étendant sous la région active 104 et s'étend latéralement au-delà de la région active 104. La deuxième sous-couche s'étend par exemple contre toute la couche métallique inférieure 111.

Dans ce mode de réalisation, le premier côté 107 de l'empilement 103 ne s'étend que sur une certaine hauteur (mesurée perpendiculairement au substrat 102) de l'empilement 103. En particulier, il s'étend sur toute la hauteur de la région active 104 et toute la hauteur de la couche de confinement supérieure 106. Le premier côté 107 ne s'étend, en revanche, que contre une partie seulement de la hauteur de la couche de confinement inférieure 105, en particulier sur toute la hauteur de la première sous-couche de la couche de confinement inférieure 105. De la même manière, dans ce mode de réalisation, le deuxième côté 108 de l'empilement 103 ne s'étend que sur la hauteur de la région active 104, la hauteur de la couche de confinement supérieure 106 et la hauteur de la première sous-couche de la couche de confinement inférieure 105.

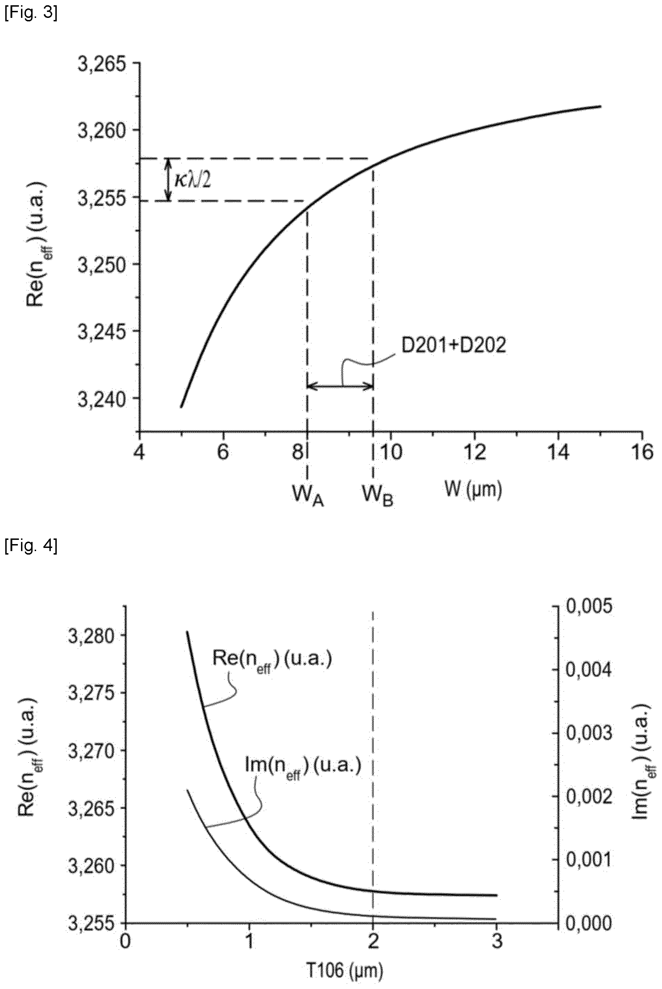

La figure 3 montre un résultat d'une analyse modale réalisée par éléments finis permettant d'ajuster les profondeurs D201, D202 des réseaux de diffraction 201, 202 pour obtenir une force de couplage totale $\kappa$ prédéfinie. La figure 3 montre plus particulièrement le résultat d'une étude paramétrique de l'indice effectif $n_{\text{eff}}$ vu par un mode guidé TM00 (polarisation perpendiculaire au substrat 102) dans un empilement 103 selon l'invention mais sans corrugation sur ces côtés (c'est-à-dire avec des côtés plats), et en fonction de la largeur W de l'empilement 103 (constante sur toute la longueur de l'empilement, sans piédestal).

L'analyse modale est réalisée en considérant un indice effectif $n_{\text{eff}}$ complexe, c'est-à-dire comprenant une partie réelle et une partie imaginaire. La partie imaginaire rend compte des pertes optiques du mode guidé dans la cavité 120.

La figure 3 montre l'évolution de la partie réelle de l'indice effectif Re($n_{\text{eff}}$) vu par le mode guidé à mesure que la largeur W de l'empilement 103 augmente. Cette évolution permet de déterminer, pour deux largeurs distinctes $W_A$ et $W_B$, un contraste d'indice $\Delta n_{\text{eff}}$ ($W_B$ - $W_A$) associé. Puisque la force de couplage avec les réseaux latéraux 201, 202 dépend du contraste d'indice $\Delta n_{\text{eff}}$, il est possible, grâce à cette étude paramétrique, de déterminer les profondeurs D201, D202 (par exemple égale à ($W_B$ - $W_A$)/2) des premier et deuxième réseaux latéraux 201, 202. Les largeurs $W_A$ et $W_B$ correspondent aux largeurs extrêmales W0 et W1 de l'empilement 103 de la figure 2. En exemple, considérant $W_A$ = 8 $\mu$m et $W_B$ = 9,5 $\mu$m, la somme des profondeurs permettant d'atteindre une force couplage $\kappa$ = 2 $\Delta n_{\text{eff}}/\lambda$ souhaitée est par exemple de

$$D201 + D202 = W_B - W_A = 1{,}5\ \mu\text{m}$$

Chaque réseau latéral 201, 202 peut ainsi présenter, pour la force couplage $\kappa$ souhaitée, une profondeur D201, D202 de 0,75 $\mu$m.

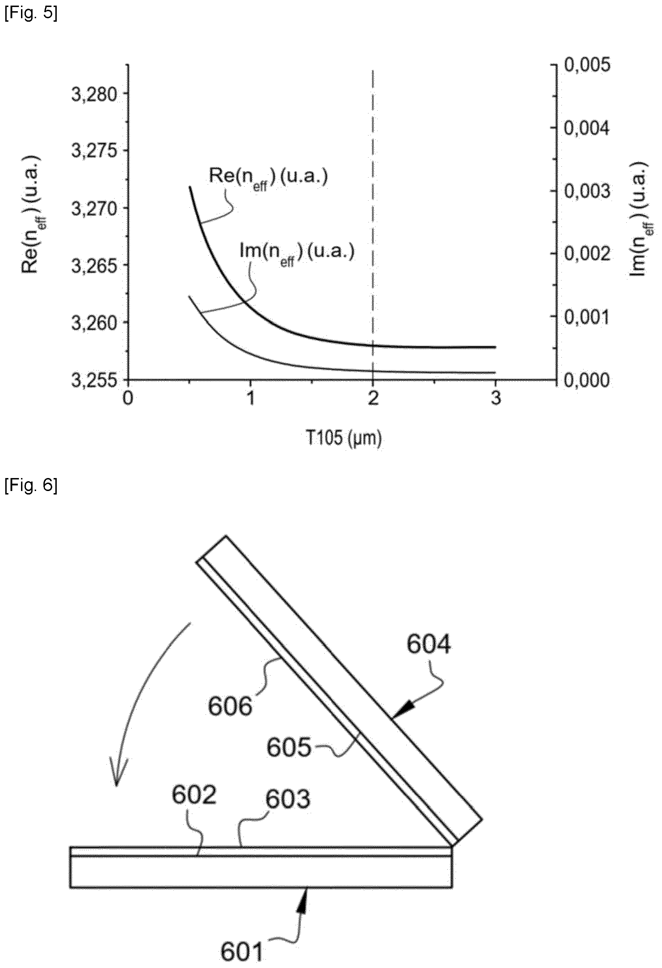

Les figures 4 et 5 montrent des résultats de deux études paramétriques des parties réelles Re($n_{\text{eff}}$) et imaginaires Im($n_{\text{eff}}$) de l'indice effectif vu par le mode guidé dans une cavité optique 120 selon l'invention. Les études paramétriques sont réalisées en fonction de, respectivement, l'épaisseur T106 de la couche de confinement supérieure 106 (figure 4) et l'épaisseur T105 de la couche de confinement inférieure 105 (figure 5).

La partie imaginaire Im($n_{\text{eff}}$) rend compte des pertes optiques du mode guidé dans la cavité 120. Elle correspond notamment au couplage du mode guidé avec la couche métallique supérieure 118 (pour la figure 4) et la couche métallique 111 inférieure (pour la figure 5). Plus la partie imaginaire Im($n_{\text{eff}}$) est élevée et plus les pertes optiques sont importantes.

Les pertes optiques (et donc la partie imaginaire Im($n_{\text{eff}}$) de l'indice effectif) décroissent de manière monotone avec les épaisseurs T105, T106. Il y a donc lieu d'augmenter l'épaisseur T105, T106 des couches de confinement 105, 106 pour réduire les pertes optiques. À faible épaisseur T105, T106, la décroissance des pertes peut être rapide. Il existe toutefois une épaisseur à partir de laquelle les pertes ne décroissent pas plus rapidement qu'un régime asymptotique. Lorsque ce régime est atteint, la diminution des pertes optiques se fait au détriment d'un épaississement conséquent des couches de confinement. Il est donc judicieux d'identifier l'épaisseur T105, T106 à partir de laquelle le régime asymptotique est atteint. Ainsi, la sélection d'une épaisseur T105, T106 permettant d'obtenir une réduction asymptotique des pertes présente un bon compromis entre épaisseur réduite et pertes acceptables.

À noter qu'à mesure que les épaisseurs T105, T106 des couches de confinement 105, 106 augmente, la partie réelle de l'indice effectif atteint également un régime asymptotique vers une valeur fixe de l'indice effectif.

La figure 6 montre schématiquement une étape de fabrication d'une source lumineuse 1 selon l'invention. La fabrication est réalisée à partir de deux substrats 601, 604. Le premier substrat 601 formera le substrat 102 sur lequel s'étend l'empilement 103 de la source lumineuse 1. Il est par exemple en silicium. Le premier substrat 601 présente une première face 602.

Le deuxième substrat 604 formera la première couche de confinement 105 de l'empilement 103. Il est par exemple en InP. Il comprend une deuxième face 605.

Dans ce mode de mise en oeuvre, les premier et deuxième substrats 601, 604 présentent des premier et deuxième indices optiques $n_{601}$, $n_{604}$ tel que $n_{601} > n_{604}$. Ainsi, le premier substrat 601 est susceptible d'induire des pertes optiques par transmission des modes guidés.

La fabrication de la source 1 comprend une étape de métallisation des première et deuxième faces 602, 605 des premier et deuxième substrat 601, 604, formant des première et deuxième sous-couches métalliques 603, 606. Le report des faces 602, 605 métallisées l'une contre l'autre est réalisé de manière à coller le deuxième substrat 604 sur le premier substrat 601.

Les deux sous-couches métalliques 603, 606 forment une première et unique couche métallique 111 s'étendant entre les deux substrats 601, 604. Cette première couche métallique 111 est destinée à former la couche métallique inférieure 111 de la source 1, s'éparant l'empilement 103 du substrat 102 en silicium.

La fabrication de la source 1 peut comprendre une étape ultérieure de formation d'un empilement de couche à partir des deux substrat 601, 604 collés. La formation comprend par exemple une gravure du deuxième substrat 604 de manière à former la couche de confinement inférieure 105 de l'empilement 103, s'étendant contre la couche métallique inférieure 111. La gravure est par exemple réalisée à travers un masque dur, avec arrêt sur la couche métallique inférieure 111. La région active 104 et la couche de confinement supérieure 106 peuvent être déposées sur la couche de confinement inférieure 105. Alternativement, avant la délimitation de la couche de confinement inférieure 105, des couches destinées à former la région active 104 et la couche de confinement supérieure 106 sont déposées sur le deuxième substrat 604. Ainsi, la délimitation de la couche de confinement inférieure 105 dans le deuxième substrat 604 délimite dans le même temps la région active 104 et la couche de confinement supérieure 106.

Cette délimitation (des couches de confinement inférieure et supérieure 105, 106 et de la région active 104) est préférentiellement réalisée de sorte que l'empilement 103 final comprenne au moins une corrugation sur l'un des ses côtés 107, 108. Cette corrugation permet de former le réseau de diffraction 201 permettant d'appliquer une contreréaction sur un mode résonant. La corrugation est par exemple obtenue à travers un masque de gravure présentant un bord crénelé.

Le procédé comprend avantageusement le dépôt de manière conforme des couches isolantes 115, 117 sur les côtés de l'empilement 103 et notamment contre la ou les corrugations latérales. Le procédé comprend également de manière avantageuse le dépôt conforme des couches métalliques latérales 112, 113 contre les couches isolantes 115, 117.

Les indices optiques des couches formant l'empilement 103 peuvent être choisis de sorte qu'au moins un mode stationnaire d'un champ électromagnétique dans l'empilement présente un indice optique effectif $n_{eff}$. L'empilement résultant s'étend sur une première couche métallique 111, cette dernière permettant de limiter la propagation des modes guidés vers le premier substrat 601, même si ce dernier présente un indice optique plus élevé que l'indice optique effectif $n_{eff}$ vu par les modes guidés.

Les épaisseurs T105, T106 des première et deuxième couches de confinement 105, 106 sont préférentiellement déterminées de sorte que les pertes optiques associées à au moins un des modes guidés de l'empilement 103 décroissent selon un régime asymptotique. Les étapes de formation des première et deuxième couches de confinement 105, 106 sont alors réalisées de sorte que ces couches 105, 106 présente les épaisseurs déterminées. Ces épaisseurs T105, T106 sont préférentiellement calculées au moyen d'analyses paramétriques telles qu'illustrées par les figures 4 et 5.

## Revendications

1. Source lumineuse (101) comprenant :

   - un substrat (102) s'étendant parallèlement à un plan ;
   - une cavité résonante à contreréaction répartie (120), configurée pour qu'au moins un mode stationnaire d'un champ électromagnétique, dit « mode guidé résonants », s'établisse parallèlement au substrat (102), ladite cavité résonante comprenant un empilement (103) de :

     - une première couche de confinement (105), dite « couche de confinement inférieure », s'étendant parallèlement au substrat (102) ;
     - une couche active (104), configurée pour générer ledit champ électromagnétique, ladite couche active (140) s'étendant sur la couche de confinement inférieure (105) ;
     - une deuxième couche de confinement (106), dite « couche de confinement supérieure », s'étendant sur la couche active (104),

   la source étant **caractérisée en ce que** le substrat présente un indice optique plus élevé que l'indice effectif vu par les modes guidés résonants dans la cavité résonante et **en ce que** la cavité résonante (120) comprend une couche métallique (111), dite « couche métallique inférieure », configurée pour interdire la transmission des modes guidés résonants, la couche métallique inférieure s'étendant parallèlement au substrat (102), entre le substrat (102) et l'empilement de couches (103) et **en ce que** la couche de confinement inférieure (105) s'étend contre la couche métallique inférieure (111).

2. Source (101) selon la revendication précédente, dans lequel l'empilement de couches (103) présente une hauteur, mesurée perpendiculairement au substrat, l'empilement de couches (103) comprenant en outre un premier côté (107), s'étendant perpendiculairement au substrat (102) sur au moins une partie de la hauteur de l'empilement de couches et s'étendant parallèlement à une première direction (X) parallèle au substrat (102) dite « direction de propagation », l'empilement de couches (103) présentant, sur son premier côté (107), un premier réseau de diffraction (201) configuré pour appliquer une contreréaction répartie sur ledit au moins un mode guidé résonant.

3. Source (101) selon la revendication précédente, dans lequel l'empilement de couches (103) présente une largeur (W0, W1), mesurée perpendiculairement à la direction de propagation (X), le premier réseau de diffraction (201) étant formé de sorte que la largeur (W0, W1) de l'empilement de couches varie périodiquement en fonction d'une position le long de la direction de propagation (X).

4. Source (101) selon l'une des deux revendications précédentes, dans lequel le premier réseau de diffraction (201) présente une première longueur (L201), mesurée selon la direction de propagation (X), et, pour au moins un mode guidé résonant de la cavité résonante (120), une première force de couplage avec ledit mode guidé résonant, le produit de la première force de couplage pour ledit au moins un mode guidé résonant avec la première longueur (L201) du réseau de diffraction étant compris entre 1 et 2,5.

5. Source (101) selon l'une des trois revendications précédentes, dans lequel l'empilement de couches (103) comprend un deuxième côté (108), opposé au premier côté, et s'étendant sur au moins une partie de la hauteur de l'empilement de couches, l'empilement de couches (103) présentant, sur son deuxième côté (108), un deuxième réseau de diffraction (201) configuré pour appliquer une contreréaction répartie sur ledit au moins un mode guidé résonant, le premier réseau de diffraction (201) présentant un premier pas (P201) et le deuxième réseau de diffraction (202) présentant un deuxième pas (P202) égal au premier pas (P201).

6. Source (1) selon l'une des revendications 2, 3 ou 4, dans lequel l'empilement de couches (103) présente une première face (109), dite « face inférieure » et une deuxième face (110), dite « face supérieure », opposée à la face inférieure (109), la couche métallique inférieure (111) s'étendant contre la face inférieure (109) de l'empilement de couches (103), l'empilement de couches (103) présentant, sur sa face supérieure (110), un troisième réseau de diffraction configuré pour appliquer une contreréaction répartie sur ledit au moins un mode guidé résonant, le premier réseau de diffraction (201) présentant un premier pas (P201) et le troisième réseau de diffraction présentant un troisième pas égal au premier pas (P201).

7. Source (1) selon l'une des revendications précédentes, dans lequel la couche de confinement inférieure (105) présente une première épaisseur (T105), mesurée perpendiculairement au substrat (102), pour laquelle les pertes optiques d'au moins un mode guidé résonant de l'empilement (103) sont fonction de la première épaisseur (T105) selon un régime asymptotique.

8. Source (101) selon l'une des trois revendications précédentes, dans lequel dans lequel l'empilement de couches (103) présente une face inférieure (109) et une face supérieure (110) opposée à la face inférieure (109), la couche métallique inférieure (111) s'étendant contre la face inférieure (109), la cavité résonante (120) comprenant également une couche métallique additionnelle (118), dite « couche métallique supérieure », s'étendant contre la face supérieure (110) de l'empilement (103), la couche de confinement supérieure (106) présentant une deuxième épaisseur (T106), mesurée perpendiculairement au substrat (102), pour laquelle les pertes optiques d'au moins un mode guidé résonant de l'empilement (103) sont fonction de la deuxième épaisseur (T106) selon un régime asymptotique.

9. Source (101) selon l'une des revendications précédentes, dans lequel la couche métallique inférieure (111) est réalisée à partir de Au, Ag ou Ti.

10. Procédé de fabrication d'une source lumineuse comprenant les étapes de

   - fournir un premier substrat (601) présentant une première face (602) ;
   - fournir un deuxième substrat (604) présentant une deuxième face (605) ;
   - métalliser la première face (602) du premier substrat (601) de manière à former une première sous-couche métallique (603) s'étendant sur la première face (602) du premier substrat (601) ;
   - métalliser la deuxième face (605) du deuxième substrat (604) de manière à former une deuxième sous-couche métallique (606) s'étendant sur la deuxième face (605) du deuxième substrat (604) ;
   - reporter la deuxième sous-couche métallique (606) du deuxième substrat (604) sur la première sous-couche métallique (603) du premier substrat (601) de sorte que les première et deuxième sous-couches métalliques (603, 606) forment une couche métallique (111), dite « couche métallique inférieure », s'étendant parallèlement au premier substrat (601) ;
   - former une cavité résonante à contreréaction répartie (120) configurée pour qu'au moins un mode stationnaire d'un champ électromagnétique, dit « mode guidé résonant », s'établisse parallèlement au premier substrat (602), la formation de la cavité résonante (120) comprenant les étapes de :

      - graver le deuxième substrat (604) de manière à former une première couche de confinement (105), dite « couche de confinement inférieure », s'étendant parallèlement au premier substrat (601) et contre la couche métallique inférieure (111 ;
- former une couche active (104), configurée pour générer ledit champ électromagnétique, ladite couche active, s'étendant sur la couche de confinement inférieure (105 ; et
- former une deuxième couche de confinement (106), dite « couche de confinement supérieure », s'étendant sur la couche active (104),

le substrat présentant un indice optique plus élevé que l'indice effectif vu par les modes guidés résonants dans la cavité résonante et la « couche métallique inférieure » étant configurée pour interdire la transmission des modes guidés résonants.

**11.** Procédé de fabrication selon la revendication précédente, comprenant une étape de détermination d'une première épaisseur (T105) pour la couche de confinement inférieure (105), pour laquelle les pertes optiques d'au moins un mode guidé résonant de la cavité résonante (120) sont fonction de cette première épaisseur (T105) selon un régime asymptotique, l'étape de gravure du deuxième substrat (604) étant réalisée de sorte que la couche de confinement inférieure (105) résultante présente la première épaisseur (T105) déterminée.

**12.** Procédé de fabrication selon l'une des deux revendications précédentes, comprenant une étape de détermination d'une deuxième épaisseur (T106) pour la couche de confinement supérieure (106), pour laquelle les pertes optiques d'au moins un mode guidé résonant de la cavité résonante (120) sont fonction de cette deuxième épaisseur (T106) selon un régime asymptotique, l'étape de formation de la couche de confinement supérieure (106) étant réalisée de sorte que la couche de confinement supérieure (106) résultante présente la deuxième épaisseur (T106) déterminée.

**13.** Procédé de fabrication selon l'une des trois revendications précédentes, comprenant une gravure de l'empilement de couches (103) de sorte que ledit empilement de couches (103), présentant une hauteur mesurée perpendiculairement au premier substrat (601), comprenne un premier côté (107), s'étendant perpendiculairement au premier substrat (601) sur au moins une partie de la hauteur de l'empilement de couches et s'étendant parallèlement à une première direction parallèle au premier substrat (601) dite « direction de propagation » (X), la gravure de l'empilement de couches (103) étant réalisée de sorte que l'empilement de couches (103) présente, sur son premier côté (107), un premier réseau de diffraction (201) configuré pour appliquer une contreréaction répartie sur ledit au moins un mode guidé résonant.

**14.** Procédé de fabrication selon la revendication précédente, comprenant une étape de dépôt conforme d'une première couche isolante (115) contre le premier côté (107) de l'empilement de couches (103) et une étape de dépôt conforme d'une couche métallique supplémentaire (112) sur la première couche isolante (115).

[Fig. 1]

[Fig. 2]

[Fig. 3]

[Fig. 4]

[Fig. 5]

[Fig. 6]

Europäisches
Patentamt

European
Patent Office

Office européen
des brevets

**RAPPORT DE RECHERCHE EUROPEENNE**

Numéro de la demande

EP 24 21 8706

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2011/101250 A1 (HU QING [US]) 5 mai 2011 (2011-05-05) | 1-3,9, 10,13 | INV. H01S5/02 |
| Y | * alinéas [0095] - [0100]; figures 6A,6B,15A,15B * | 4,7,8, 11,12 | H01S5/12 H01S5/22 H01S5/10 |
| | ----- | | |
| A | US 7 548 566 B2 (MASSACHUSETTS INST TECHNOLOGY) 16 juin 2009 (2009-06-16) * le document en entier * | 1-14 | ADD. H01S5/34 H01S5/20 |
| | ----- | | H01S5/32 |
| X | US 2022/344476 A1 (CHAN PHILIP [US] ET AL) 27 octobre 2022 (2022-10-27) | 1-3,5,6, 9,10,13, 14 | |
| Y | * alinéas [0013], [0316], [0323], [0324], [0361] - [0365]; figures 1,15,16,21 * | 4,7,8, 11,12 | |
| | ----- | | |
| X | CHEN TING ET AL: "FUNDAMENTAL AREAS OF PHENOMENOLOGY (INCLUDING APPLICATIONS); Electrically Pumped Room-Temperature Pulsed InGaAsP-Si Hybrid Lasers Based on Metal Bonding", CHINESE PHYSICS LETTERS, INSTITUTE OF PHYSICS PUBLISHING, BRISTOL, GB, vol. 26, no. 6, 2009, page 64211, XP020159039, ISSN: 0256-307X * Tables 1,2; figure 1 * | 1 | **DOMAINES TECHNIQUES RECHERCHES (IPC)** H01S |
| | ----- | | |
| X | US 2022/045482 A1 (GAO FENG [SG] ET AL) 10 février 2022 (2022-02-10) * figures 1,2,8,9 * | 1 | |
| | ----- | | |
| | -/-- | | |

Le présent rapport a été établi pour toutes les revendications

| Lieu de la recherche | Date d'achèvement de la recherche | Examinateur |
|---|---|---|
| Munich | 1 avril 2025 | Moskowitz, Pamela |

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

EP 24 21 8706

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | APIRATIKUL PAVEEN ET AL: "GaInAsSb-AlGaAsSb laterally coupled distributed-feedback metamorphic laser grown on a GaAs substrate at 2", CLEO: 2013, THE OPTICAL SOCIETY, 9 juin 2013 (2013-06-09), pages 1-2, XP032602372, DOI: 10.1364/CLEO_SI.2013.CM2K.4 * le document en entier * | 4 | |
| Y | US 2021/336412 A1 (NAKAO RYO [JP] ET AL) 28 octobre 2021 (2021-10-28) * le document en entier * | 7,8,11, 12 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 1 avril 2025 | Moskowitz, Pamela |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

....................................................................

& : membre de la même famille, document correspondant

EPO FORM 1503 03.82 (P04C02)

page 2 de 2

# EP 4 572 040 A1

## ANNEXE AU RAPPORT DE RECHERCHE EUROPEENNE
## RELATIF A LA DEMANDE DE BREVET EUROPEEN NO.

EP 24 21 8706

01-04-2025

| Document brevet cité au rapport de recherche | Date de publication | Membre(s) de la famille de brevet(s) | | Date de publication |
|---|---|---|---|---|
| US 2011101250 A1 | 05-05-2011 | EP | 2497167 A2 | 12-09-2012 |
| | | US | 2011101250 A1 | 05-05-2011 |
| | | US | 2014008553 A1 | 09-01-2014 |
| | | WO | 2011102862 A2 | 25-08-2011 |
| US 7548566 B2 | 16-06-2009 | US | 2005058168 A1 | 17-03-2005 |
| | | US | 2007104238 A1 | 10-05-2007 |
| US 2022344476 A1 | 27-10-2022 | AUCUN | | |
| US 2022045482 A1 | 10-02-2022 | CN | 113812049 A | 17-12-2021 |
| | | SG | 10201811773X A | 29-07-2020 |
| | | US | 2022045482 A1 | 10-02-2022 |
| | | WO | 2020139197 A1 | 02-07-2020 |
| US 2021336412 A1 | 28-10-2021 | CN | 110637400 A | 31-12-2019 |
| | | JP | 6738488 B2 | 12-08-2020 |
| | | JP | WO2018212195 A1 | 07-11-2019 |
| | | US | 2021336412 A1 | 28-10-2021 |
| | | WO | 2018212195 A1 | 22-11-2018 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **COUTARD, J.G.** ; **BRUN, M.** ; **FOURNIER, M. et al.** Volume Fabrication of Quantum Cascade Lasers on 200 mm-CMOS pilot line. *Sci Rep*, 2020, vol. 10, 6185